(19) **Europäisches Patentamt European Patent Office Office européen des brevets**

(11) **EP 4 545 994 A1**

(12) **EUROPEAN PATENT APPLICATION**
published in accordance with Art. 153(4) EPC

(43) Date of publication:
30.04.2025 Bulletin 2025/18

(21) Application number: 22956787.0

(22) Date of filing: 30.08.2022

(51) International Patent Classification (IPC):
$G01R\ 31/396^{(2019.01)}$    $G01R\ 31/392^{(2019.01)}$
$G01R\ 31/389^{(2019.01)}$    $G01R\ 31/3842^{(2019.01)}$
$H01M\ 10/48^{(2006.01)}$

(52) Cooperative Patent Classification (CPC):
G01R 31/3842; G01R 31/389; G01R 31/392;
G01R 31/396; H01M 10/48

(86) International application number:
PCT/CN2022/115790

(87) International publication number:
WO 2024/044955 (07.03.2024 Gazette 2024/10)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Huawei Digital Power Technologies Co., Ltd.**
**Shenzhen, Guangdong 518043 (CN)**

(72) Inventors:
• **XIONG, Cheng**
 **Shenzhen, Guangdong 518043 (CN)**
• **HOU, Tianhong**
 **Shenzhen, Guangdong 518043 (CN)**
• **XIE, Jie**
 **Shenzhen, Guangdong 518043 (CN)**

(74) Representative: **Maiwald GmbH**
**Engineering**
**Elisenhof**
**Elisenstrasse 3**
**80335 München (DE)**

(54) **BATTERY PACK AND MEASUREMENT METHOD THEREFOR, AND BATTERY MANAGEMENT SYSTEM**

(57) This application discloses a battery pack and a detection method thereof, and a battery management system BMS, to detect an abnormal connection between battery subpacks in the battery pack in time. The battery pack includes a plurality of battery subpacks and voltage detection circuits, a current detection circuit, and a BMS. The plurality of battery subpacks are connected in series to a charge/discharge loop of the battery pack. Each battery subpack and one connection component connected to the battery subpack form one to-be-detected assembly. The current detection circuit is configured to detect a current of the charge/discharge loop. The voltage detection circuit is configured to detect voltages at two ends of the to-be-detected assembly. The BMS is configured to: obtain the current of the charge/discharge loop and voltages at two ends of each to-be-detected assembly based on a preset period, generate a current sequence and a first voltage sequence of each to-be-detected assembly, calculate an impedance of each to-be-detected assembly based on the current sequence and the first voltage sequence, and when the impedance is greater than or equal to an impedance threshold, determine that the connection component in the to-be-detected assembly is abnormally connected.

FIG. 1

Processed by Luminess, 75001 PARIS (FR)

## Description

## TECHNICAL FIELD

This application relates to the field of battery technologies, and in particular, to a battery pack, a detection method thereof, and a battery management system.

## BACKGROUND

Lithium-ion batteries feature high energy density and high power density, and therefore are widely used in scenarios with a large-scale energy storage system, such as an electric vehicle and a data center. To meet an energy requirement in the large-scale energy storage scenario, currently, a battery pack is formed by connecting a plurality of battery cells in series to form a battery module, and then connecting the battery module to another battery module in series through a conductive connecting piece.

When the battery pack is in use, a connection component between battery modules or battery cells may be aged and decayed, or become abnormally loose at an end of system reliability. As a result, an impedance of the connection component increases abnormally, and the increased impedance causes the connection component to heat up abnormally when a current flows. When the current is high, a temperature of the connection component quickly rises to a high temperature. Under action of a continuous high temperature, a capacity of the battery pack may be abnormally attenuated, or even thermal runaway may occur, causing a fire. Therefore, how to detect an abnormal connection between battery modules or battery cells in time has become an urgent technical problem to be resolved currently.

## SUMMARY

This application provides a battery pack, a detection method thereof, and a battery management system, to detect an abnormal connection between battery subpacks in the battery pack in time, and improve use safety of the battery pack.

According to a first aspect, this application provides a battery pack. The battery pack includes a plurality of battery subpacks and voltage detection circuits, a current detection circuit, and a battery management system BMS. The plurality of battery subpacks are connected in series to a charge/discharge loop of the battery pack, and two adj acent battery subpacks may be connected by using a connection component. Each battery subpack and one connection component connected to an end of the battery subpack may form one to-be-detected assembly. The current detection circuit may be configured to detect a current of the charge/discharge loop of the battery pack. The voltage detection circuit and the to-be-detected assembly may be disposed in a one-to-one correspondence, and the voltage detection circuit is configured to detect voltages at two ends of the corresponding to-be-detected assembly. The BMS may be configured to: separately obtain the current of the charge/discharge loop and voltages at two ends of each to-be-detected assembly based on a preset period, generate a current sequence and a first voltage sequence of each to-be-detected assembly, separately calculate an impedance of each to-be-detected assembly based on the current sequence and the first voltage sequence, and when the impedance of the to-be-detected assembly is greater than or equal to an impedance threshold, determine that the connection component in the to-be-detected assembly is abnormally connected.

In the foregoing solution, the impedance of the to-be-detected assembly is calculated, and whether the connection component in the to-be-detected assembly is faulty can be effectively determined. This can detect an abnormal connection between battery subpacks in the battery pack in time, and improve use safety of the battery pack.

In some possible implementation solutions, the BMS may be specifically configured to: when the current sequence meets a preset condition, separately calculate the impedance of each to-be-detected assembly based on the current sequence and the first voltage sequence. Before the impedance of the to-be-detected assembly is calculated, whether the current sequence meets the preset condition is determined. This can improve accuracy of subsequently determining whether the connection component is abnormally connected.

In some possible implementation solutions, when the current sequence does not meet the preset condition, for example, in some scenarios with an energy storage power plant, the battery pack is in a constant current charging or discharging state, and the BMS may be configured to: control the battery pack to be charged or discharged based on a preset current sequence; obtain voltages at the two ends of each to-be-detected assembly when the battery pack is charged or discharged based on the preset current sequence; and generate a second voltage sequence of each to-be-detected assembly; and separately calculate the impedance of each to-be-detected assembly based on the preset current sequence and the second voltage sequence, and when the impedance is greater than or equal to the impedance threshold, determine that the connection component in the to-be-detected assembly is abnormally connected.

In some other possible implementation solutions, if the collected current sequence does not meet the preset condition, and the battery pack does not meet a running scenario in which the battery pack is excited based on the preset current sequence, the BMS may be configured to: calculate the impedance of each to-be-detected assembly based on intrinsic information of the battery pack, and when the impedance is greater than or equal to the impedance threshold, determine that the connection component in the to-be-detected assembly is abnormally connected.

For example, the intrinsic information of the battery pack may specifically include information such as an open-circuit voltage, a state of charge, and an internal resistance.

In the foregoing solutions, the preset condition may be specifically that a standard deviation of the current sequence is greater than or equal to a specified threshold. The specified threshold may be set based on experience or experimental data.

In some possible implementation solutions, before determining whether the current sequence meets the preset condition, the BMS may be configured to determine that absolute values of differences between voltage values at one or more moments in the first voltage sequence and a voltage threshold are greater than or equal to a voltage difference threshold. If the first voltage sequence meets the condition, it indicates that there is a risk of an abnormal connection of the connection component in the to-be-detected assembly. In this case, determining of the current sequence may be performed for further confirmation.

For example, the voltage threshold may be a median or an average number of voltage values at one or more moments in each first voltage sequence. Alternatively, the voltage threshold may be a determined value pre-stored in the BMS. In this case, the voltage threshold may be set based on experience or experimental data. In addition, the voltage difference threshold may also be set based on experience or experimental data, and be pre-stored in the BMS.

In some possible implementation solutions, the battery pack may further include a warner. In this case, the BMS may be configured to: after determining that the abnormal connection occurs on the connection component, determine an abnormal risk level based on the impedance of the to-be-detected assembly, and control, based on the abnormal risk level, the warner to perform a corresponding warning, for example, control a trip unit of the battery pack to perform tripping processing, to cut off the charge/discharge loop of the battery pack.

In some possible implementation solutions, the battery subpack may be a battery module, the battery pack includes a plurality of battery modules connected in series, and each battery module includes a plurality of battery cells connected in series. Alternatively, the battery subpack may be a battery cell, and the battery pack includes a plurality of battery cells connected in series. Based on this, in this application, only a topology structure of a detection circuit is changed without increasing hardware costs of a sampling detection circuit, to be specific, a connection status between battery modules and a connection status between battery cells can be detected. Therefore, costs of the battery pack can be effectively reduced.

According to a second aspect, this application further provides a battery pack. The battery pack includes a plurality of battery subpacks and voltage detection circuits, a current detection circuit, and a battery management system BMS. The plurality of battery subpacks are connected in series to a charge/discharge loop of the battery pack, and two adjacent battery subpacks may be connected by using a connection component. Each battery subpack and one connection component connected to an end of the battery subpack may form one to-be-detected assembly. The current detection circuit may be configured to detect a current of the charge/discharge loop of the battery pack. The voltage detection circuit and the to-be-detected assembly may be disposed in a one-to-one correspondence, and the voltage detection circuit is configured to detect voltages at two ends of the corresponding to-be-detected assembly. The BMS may be configured to: separately obtain the current of the charge/discharge loop and voltages at two ends of each to-be-detected assembly based on a preset period, generate a current sequence and a first voltage sequence of each to-be-detected assembly, when the current sequence meets a preset condition, separately calculate an impedance of each to-be-detected assembly based on the current sequence and the first voltage sequence, and when the impedance of the to-be-detected assembly is greater than or equal to an impedance threshold, determine that the connection component in the to-be-detected assembly is abnormally connected; and/or when the current sequence does not meet the preset condition, control the battery pack to be charged or discharged based on the preset current sequence; obtain voltages at the two ends of each to-be-detected assembly when the battery pack is charged or discharged based on the preset current sequence, and generate a second voltage sequence of each to-be-detected assembly; and separately calculate an impedance of each to-be-detected assembly based on the preset current sequence and the second voltage sequence; and when the impedance is greater than or equal to an impedance threshold, determine that the connection component in the to-be-detected assembly is abnormally connected.

In the foregoing solution, whether the current sequence meets the preset condition is determined, and the impedance of the to-be-detected assembly is separately calculated in different manners when the current sequence meets the preset condition and when the current sequence does not meet the preset condition. This accurately and effectively determines whether the connection component in the to-be-detected assembly is faulty, detects an abnormal connection between battery subpacks in the battery pack in time, and improves use safety of the battery pack.

The preset condition may be specifically that a standard deviation of the current sequence is greater than or equal to a specified threshold. The specified threshold may be set based on experience or experimental data.

In some possible implementation solutions, before determining whether the current sequence meets the preset condition, the BMS may be configured to determine that absolute values of differences between voltage values at one or more moments in the first voltage sequence and a voltage threshold are greater than or equal to a voltage difference threshold. If the first voltage sequence meets the condition, it indicates that there is a risk of an abnormal connection of the connection component in the to-be-detected assembly. In this case, determining of the current sequence may be performed for further confirmation.

For example, the voltage threshold may be a median or an average number of voltage values at one or more moments in each first voltage sequence. Alternatively, the voltage threshold may be a determined value pre-stored in the BMS. In this case, the voltage threshold may be set based on experience or experimental data. In addition, the voltage difference threshold may also be set based on experience or experimental data, and be pre-stored in the BMS.

In some possible implementation solutions, the battery pack may further include a warner. In this case, the BMS may be configured to: after determining that the abnormal connection occurs on the connection component, determine an abnormal risk level based on the impedance of the to-be-detected assembly, and control, based on the abnormal risk level, the warner to perform a corresponding warning, for example, control a trip unit of the battery pack to perform tripping processing, to cut off the charge/discharge loop of the battery pack.

In some possible implementation solutions, the battery subpack may be a battery module, the battery pack includes a plurality of battery modules connected in series, and each battery module includes a plurality of battery cells connected in series. Alternatively, the battery subpack may be a battery cell, and the battery pack includes a plurality of battery cells connected in series. Based on this, in this application, only a topology structure of a detection circuit is changed without increasing hardware costs of a sampling detection circuit, to be specific, a connection status between battery modules and a connection status between battery cells can be detected. Therefore, costs of the battery pack can be effectively reduced.

According to a third aspect, this application further provides a battery pack. The battery pack includes a plurality of battery subpacks and voltage detection circuits, a current detection circuit, and a battery management system BMS. The plurality of battery subpacks are connected in series to a charge/discharge loop of the battery pack, and two adjacent battery subpacks may be connected by using a connection component. Each battery subpack and one connection component connected to an end of the battery subpack may form one to-be-detected assembly. The current detection circuit may be configured to detect a current of the charge/discharge loop of the battery pack. The voltage detection circuit and the to-be-detected assembly may be disposed in a one-to-one correspondence, and the voltage detection circuit is configured to detect voltages at two ends of the corresponding to-be-detected assembly. The BMS may be configured to: separately obtain the current of the charge/discharge loop and voltages at two ends of each to-be-detected assembly based on a preset period, generate a current sequence and a first voltage sequence of each to-be-detected assembly, when the current sequence meets a preset condition, separately calculate an impedance of each to-be-detected assembly based on the current sequence and the first voltage sequence, and when the impedance of the to-be-detected assembly is greater than or equal to an impedance threshold, determine that the connection component in the to-be-detected assembly is abnormally connected; and/or when the current sequence does not meet the preset condition, calculate an impedance of each to-be-detected assembly based on intrinsic information of the battery pack; and when the impedance is greater than or equal to an impedance threshold, determine that the connection component in the to-be-detected assembly is abnormally connected.

In the foregoing solution, whether the current sequence meets the preset condition is determined, and the impedance of the to-be-detected assembly is separately calculated in different manners when the current sequence meets the preset condition and when the current sequence does not meet the preset condition. This accurately and effectively determines whether the connection component in the to-be-detected assembly is faulty, detects an abnormal connection between battery subpacks in the battery pack in time, and improves use safety of the battery pack.

The preset condition may be specifically that a standard deviation of the current sequence is greater than or equal to a specified threshold. The specified threshold may be set based on experience or experimental data.

In some possible implementation solutions, before determining whether the current sequence meets the preset condition, the BMS may be configured to determine that absolute values of differences between voltage values at one or more moments in the first voltage sequence and a voltage threshold are greater than or equal to a voltage difference threshold. If the first voltage sequence meets the condition, it indicates that there is a risk of an abnormal connection of the connection component in the to-be-detected assembly. In this case, determining of the current sequence may be performed for further confirmation.

For example, the voltage threshold may be a median or an average number of voltage values at one or more moments in each first voltage sequence. Alternatively, the voltage threshold may be a determined value pre-stored in the BMS. In this case, the voltage threshold may be set based on experience or experimental data. In addition, the voltage difference threshold may also be set based on experience or experimental data, and be pre-stored in the BMS.

In some possible implementation solutions, the battery pack may further include a warner. In this case, the BMS may be configured to: after determining that the abnormal connection occurs on the connection component, determine an abnormal risk level based on the impedance of the to-be-detected assembly, and control, based on the abnormal risk level, the warner to perform a corresponding warning, for example, control a trip unit of the battery pack to perform tripping processing, to cut off the charge/discharge loop of the battery pack.

In some possible implementation solutions, the battery subpack may be a battery module, the battery pack includes a plurality of battery modules connected in series, and each battery module includes a plurality of battery cells connected in series. Alternatively, the battery subpack may be a battery cell, and the battery pack includes a plurality of battery cells connected in series. Based on this, in this application, only a topology structure of a detection circuit is changed without increasing hardware costs of a sampling detection circuit, to be specific, a connection status between battery modules and a connection status between battery cells can be detected. Therefore, costs of the battery pack can be effectively reduced.

According to a fourth aspect, this application further provides a battery pack. The battery pack includes a plurality of battery subpacks and voltage detection circuits, a current detection circuit, and a battery management system BMS. The plurality of battery subpacks are connected in series to a charge/discharge loop of the battery pack, and two adjacent battery subpacks may be connected by using a connection component. Each battery subpack and one connection component connected to an end of the battery subpack may form one to-be-detected assembly. The current detection circuit may be configured to detect a current of the charge/discharge loop of the battery pack. The voltage detection circuit and the to-be-detected assembly may be disposed in a one-to-one correspondence, and the voltage detection circuit is configured to detect voltages at two ends of the corresponding to-be-detected assembly. The BMS may be configured to: obtain the current of the charge/discharge loop based on a preset period, and generate a current sequence; when the current sequence does not meet a preset condition, control the battery pack to be charged or discharged based on the preset current sequence; obtain the voltages at the two ends of each to-be-detected assembly when the battery pack is charged or discharged based on the preset current sequence; and generate a second voltage sequence of each to-be-detected assembly; and separately calculate an impedance of each to-be-detected assembly based on the preset current sequence and the second voltage sequence, and when the impedance is greater than or equal to an impedance threshold, determine that the connection component in the to-be-detected assembly is abnormally connected.

In the foregoing solution, whether the current sequence meets the preset condition is determined, and when the current sequence does not meet the preset condition, the battery pack is controlled to be charged or discharged based on the preset current sequence, voltages at the two ends of the to-be-detected assembly in a process of charging and discharging the battery pack are obtained based on the preset current sequence, and generate a second voltage sequence. The impedance of each to-be-detected assembly is calculated based on the preset current sequence and the second voltage sequence. This accurately and effectively determines whether the connection component in the to-be-detected assembly is faulty in this scenario, detects an abnormal connection between battery subpacks in the battery pack in time, and improves use safety of the battery pack.

The preset condition may be specifically that a standard deviation of the current sequence is greater than or equal to a specified threshold. The specified threshold may be set based on experience or experimental data.

In some possible implementation solutions, before determining whether the current sequence meets the preset condition, the BMS may be configured to determine that absolute values of differences between voltage values at one or more moments in the first voltage sequence and a voltage threshold are greater than or equal to a voltage difference threshold. If the first voltage sequence meets the condition, it indicates that there is a risk of an abnormal connection of the connection component in the to-be-detected assembly. In this case, determining of the current sequence may be performed for further confirmation.

For example, the voltage threshold may be a median or an average number of voltage values at one or more moments in each first voltage sequence. Alternatively, the voltage threshold may be a determined value pre-stored in the BMS. In this case, the voltage threshold may be set based on experience or experimental data. In addition, the voltage difference threshold may also be set based on experience or experimental data, and be pre-stored in the BMS.

In some possible implementation solutions, the battery pack may further include a warner. In this case, the BMS may be configured to: after determining that the abnormal connection occurs on the connection component, determine an abnormal risk level based on the impedance of the to-be-detected assembly, and control, based on the abnormal risk level, the warner to perform a corresponding warning, for example, control a trip unit of the battery pack to perform tripping processing, to cut off the charge/discharge loop of the battery pack.

In some possible implementation solutions, the battery subpack may be a battery module, the battery pack includes a plurality of battery modules connected in series, and each battery module includes a plurality of battery cells connected in series. Alternatively, the battery subpack may be a battery cell, and the battery pack includes a plurality of battery cells connected in series. Based on this, in this application, only a topology structure of a detection circuit is changed without increasing hardware costs of a sampling detection circuit, to be specific, a connection status between battery modules and a connection status between battery cells can be detected. Therefore, costs of the battery pack can be effectively reduced.

According to a fifth aspect, this application further provides a battery pack. The battery pack includes a plurality of battery subpacks, a current detection circuit, and a battery management system BMS. The plurality of battery subpacks are connected in series to a charge/-discharge loop of the battery pack, and two adjacent battery subpacks may be connected by using a connection component. Each battery subpack and one connection component connected to an end of the battery subpack may form one to-be-detected assembly. The current detection circuit may be configured to detect a current of the charge/discharge loop of the battery pack. The BMS may be configured to: obtain the current of the charge/-discharge loop based on a preset period and generate a current sequence; when the current sequence does not meet a preset condition, calculate an impedance of each to-be-detected assembly based on intrinsic information of the battery pack; and when the impedance is greater than or equal to an impedance threshold, determine that the connection component in the to-be-detected assembly is abnormally connected. In the foregoing solution, whether the current sequence meets the preset condition is determined, and when the current sequence does not meet the preset condition, the impedance of each to-be-detected assembly is calculated based on the intrinsic information of the battery pack. This accurately and effectively determines whether the connection component in the to-be-detected assembly is faulty in this scenario, detects an abnormal connection between battery subpacks in the battery pack in time, and improves use safety of the battery pack.

The preset condition may be specifically that a standard deviation of the current sequence is greater than or equal to a specified threshold. The specified threshold may be set based on experience or experimental data.

In some possible implementation solutions, before determining whether the current sequence meets the preset condition, the BMS may be configured to determine that absolute values of differences between voltage values at one or more moments in the first voltage sequence and a voltage threshold are greater than or equal to a voltage difference threshold. If the first voltage sequence meets the condition, it indicates that there is a risk of an abnormal connection of the connection component in the to-be-detected assembly. In this case, determining of the current sequence may be performed for further confirmation.

For example, the voltage threshold may be a median or an average number of voltage values at one or more moments in each first voltage sequence. Alternatively, the voltage threshold may be a determined value pre-stored in the BMS. In this case, the voltage threshold may be set based on experience or experimental data. In addition, the voltage difference threshold may also be set based on experience or experimental data, and be pre-stored in the BMS.

In some possible implementation solutions, the battery pack may further include a warner. In this case, the BMS may be configured to: after determining that the abnormal connection occurs on the connection component, determine an abnormal risk level based on the impedance of the to-be-detected assembly, and control, based on the abnormal risk level, the warner to perform a corresponding warning, for example, control a trip unit of the battery pack to perform tripping processing, to cut off the charge/discharge loop of the battery pack.

In some possible implementation solutions, the battery subpack may be a battery module, the battery pack includes a plurality of battery modules connected in series, and each battery module includes a plurality of battery cells connected in series. Alternatively, the battery subpack may be a battery cell, and the battery pack includes a plurality of battery cells connected in series. Based on this, in this application, only a topology structure of a detection circuit is changed without increasing hardware costs of a sampling detection circuit, to be specific, a connection status between battery modules and a connection status between battery cells can be detected. Therefore, costs of the battery pack can be effectively reduced.

According to a sixth aspect, this application further provides an energy storage system. The energy storage system may include a power converter and the battery pack according to any one of the possible implementation solutions of the first to the fifth aspects. The power converter may be configured to perform power conversion on a current and/or a voltage input to the battery pack, or a current and/or a voltage output from the battery pack. The energy storage system has high use safety.

According to a seventh aspect, this application further provides a battery pack detection method. The detection method includes:

separately obtaining a current of a charge/discharge loop and voltages at two ends of each to-be-detected assembly based on a preset period, where the battery pack includes a plurality of battery subpacks, and each to-be-detected assembly includes one battery subpack and one connection component connected to an end of the battery subpack;

generating a current sequence and a first voltage sequence of each to-be-detected assembly based on the current of the charge/discharge loop and the voltages at the two ends of each to-be-detected assembly;

separately calculating an impedance of each to-be-detected assembly based on the current sequence and the first voltage sequence; and

when the impedance of the to-be-detected assembly is greater than or equal to an impedance threshold, determining that the connection component in the to-be-detected assembly is abnormally connected.

In the foregoing solution, the impedance of the to-be-detected assembly is calculated, and whether the connection component in the to-be-detected assembly is faulty can be effectively determined. This can detect an abnormal connection between battery subpacks in the battery pack in time, and improve use safety of the battery pack.

In some possible implementation solutions, the detection method further includes: when it is determined that the current sequence meets a preset condition, separately calculating the impedance of each to-be-detected assembly based on the current sequence and the first voltage sequence. Before the impedance of the to-be-detected assembly is calculated, whether the current sequence meets the preset condition is determined. This can improve accuracy of subsequently determining whether the connection component is abnormally connected.

In some possible implementation solutions, the detection method further includes: when it is determined that the current sequence does not meet the preset condition, for example, in some scenarios with an energy storage power plant, when the battery pack is in a constant current charging or discharging state, controlling the battery pack to be charged or discharged based on a preset current sequence; obtaining voltages at the two ends of each to-be-detected assembly when the battery pack is charged or discharged based on the preset current sequence, and generating a second voltage sequence of each to-be-detected assembly; and separately calculating the impedance of each to-be-detected assembly based on the preset current sequence and the second voltage sequence; and when the impedance is greater than or equal to the impedance threshold, determining that the connection component in the to-be-detected assembly is abnormally connected.

In some other possible implementation solutions, the detection method further includes: when it is determined that the current sequence does not meet the preset condition, or the battery back does not meet a running scenario in which the battery pack is excited based on the preset current sequence, calculating the impedance of each to-be-detected assembly based on intrinsic information of the battery pack, and when the impedance is greater than or equal to the impedance threshold, determining that the connection component in the to-be-detected assembly is abnormally connected.

For example, the intrinsic information of the battery pack may specifically include information such as an open-circuit voltage, a state of charge, and an internal resistance.

In the foregoing solutions, the preset condition may be specifically that a standard deviation of the current sequence is greater than or equal to a specified threshold. The specified threshold may be set based on experience or experimental data.

In some possible implementation solutions, before the determining whether the current sequence meets the preset condition, the detection method further includes: determining that absolute values of differences between voltage values at one or more moments in the first voltage sequence and a voltage threshold are greater than or equal to a voltage difference threshold. If the first voltage sequence meets the condition, it indicates that there is a risk of an abnormal connection of the connection component in the to-be-detected assembly. In this case, determining of the current sequence may be performed for further confirmation.

For example, the voltage threshold may be a median or an average number of voltage values at one or more moments in each first voltage sequence.

In some possible implementation solutions, after the determining that an abnormal connection occurs on the connection component, the detection method may further include: determining an abnormal risk level based on the impedance of the to-be-detected assembly, and controlling, based on the abnormal risk level, a warner to perform a corresponding warning, for example, controlling a trip unit of the battery pack to perform tripping processing, to cut off the charge/discharge loop of the battery pack.

According to an eighth aspect, this application further provides a battery management system. The battery management system includes:

a communication unit, where the communication unit may be configured to separately obtain a current of a charge/discharge loop and voltages at two ends of each to-be-detected assembly based on a preset period, the battery pack includes a plurality of battery subpacks, and each to-be-detected assembly includes one battery subpack and one connection component connected to an end of the battery subpack; and

a processing unit, configured to: generate a current sequence and a first voltage sequence of each to-be-detected assembly based on the current of the charge/discharge loop and the voltages at the two ends of each to-be-detected assembly;

separately calculate an impedance of each to-be-detected assembly based on the current sequence and the first voltage sequence; and

when the impedance of the to-be-detected assembly is greater than or equal to an impedance threshold, determine that the connection component in the to-be-detected assembly is abnormally connected.

In the foregoing solution, the impedance of the to-be-detected assembly is calculated, and whether the connection component in the to-be-detected assembly is faulty can be effectively determined. This can detect an abnormal connection between battery subpacks in the battery pack in time, and improve use safety of the battery pack.

In some possible implementation solutions, the processing unit may be configured to: when it is determined that the current sequence meets a preset condition, separately calculate the impedance of each to-be-detected assembly based on the current sequence and the first voltage sequence. Before the impedance of the to-be-detected assembly is calculated, whether the current sequence meets the preset condition is determined. This can improve accuracy of subsequently determining whether the connection component is abnormally connected.

In some possible implementation solutions, the processing unit may be configured to: when it is determined that the current sequence does not meet the preset condition, for example, in some scenarios with an energy storage power plant, when the battery pack is in a constant current charging or discharging state, control the battery pack to be charged or discharged based on a preset current sequence; obtain voltages at the two ends of each to-be-detected assembly when the battery pack is charged or discharged based on the preset current sequence, and generate a second voltage sequence of each to-be-detected assembly; and separately calculate the impedance of each to-be-detected assembly based on the preset current sequence and the second voltage sequence, and when the impedance is greater than or equal to the impedance threshold, determine that the connection component in the to-be-detected assembly is abnormally connected.

In some other possible implementation solutions, the processing unit may be configured to: when it is determined that the current sequence does not meet the preset condition, or the battery back does not meet a running scenario in which the battery pack is excited based on the preset current sequence, calculate the impedance of each to-be-detected assembly based on intrinsic information of the battery pack, and when the impedance is greater than or equal to the impedance threshold, determine that the connection component in the to-be-detected assembly is abnormally connected.

For example, the intrinsic information of the battery pack may specifically include information such as an open-circuit voltage, a state of charge, and an internal resistance.

In the foregoing solutions, the preset condition may be specifically that a standard deviation of the current sequence is greater than or equal to a specified threshold. The specified threshold may be set based on experience or experimental data.

In some possible implementation solutions, the processing unit may be configured to: before determining whether the current sequence meets the preset condition, determine that absolute values of differences between voltage values at one or more moments in the first voltage sequence and a voltage threshold are greater than or equal to a voltage difference threshold. If the first voltage sequence meets the condition, it indicates that there is a risk of an abnormal connection of the connection component in the to-be-detected assembly. In this case, determining of the current sequence may be performed for further confirmation.

For example, the voltage threshold may be a median or an average number of voltage values at one or more moments in each first voltage sequence.

In some possible implementation solutions, the processing unit may be configured to: after determining that an abnormal connection occurs on the connection component, determine an abnormal risk level based on the impedance of the to-be-detected assembly, and control, based on the abnormal risk level, a warner to perform a corresponding warning, for example, control a trip unit of the battery pack to perform tripping processing, to cut off the charge/discharge loop of the battery pack.

According to a ninth aspect, this application further provides a computing device. The computing device includes a processor. The processor is coupled to a memory. The memory stores program instructions, and the processor is configured to execute the program instructions, to implement the method provided in the seventh aspect.

According to a tenth aspect, this application further provides a computer-readable storage medium. The computer-readable storage medium stores a computer program or instructions. When the computer program or the instructions runs/run on a computer, the computer is enabled to implement the method provided in the seventh aspect.

According to an eleventh aspect, this application further provides a computer program. When the computer program runs on a computer, the computer is enabled to implement the method provided in the seventh aspect.

**BRIEF DESCRIPTION OF DRAWINGS**

FIG. 1 is a schematic diagram of a structure of a battery pack according to an embodiment of this application;

FIG. 2 is a schematic diagram of a structure of another battery pack according to an embodiment of this application;

FIG. 3 is a schematic diagram of a partial structure of a battery pack according to an embodiment of this application;

FIG. 4 is a schematic diagram of an architecture of a battery pack according to an embodiment of this application;

FIG. 5 shows current values of a charge/discharge loop of a battery pack;

FIG. 6 is a diagram of comparison between voltages of a battery cell with a connection fault and medians of voltages of the battery cells at different moments;

FIG. 7a is a curve diagram of a possible relationship between an open-circuit voltage and a state of charge of a battery pack;

FIG. 7b is a curve diagram of possible relationships between impedances of a battery cell in a battery pack and states of charge at different temperatures;

FIG. 8 is a flowchart of a battery pack detection method according to an embodiment of this application; and

FIG. 9 is a schematic diagram of a structure of a computing device according to an embodiment of this application.

Reference numerals:

100: battery pack;

110: battery module; 111: battery cell; 120: battery management system; 130: switching apparatus; 131: trip unit;

140: current detection circuit; 150: voltage detection circuit; 160: warner; 170: temperature detection circuit;

200: load;

300: charging power supply;

1000: computing device; 1110: processor; 1120: memory; 1130: communication interface; and 1140: bus.

## DESCRIPTION OF EMBODIMENTS

To make objectives, technical solutions, and advantages of this application clearer, the following further describes this application in detail with reference to the accompanying drawings. However, the example implementations can be implemented in a plurality of forms, and should not be construed as being limited to the implementations described herein. Identical reference numerals in the accompanying drawings denote identical or similar structures. Therefore, repeated description thereof is omitted. Expressions of positions and directions in embodiments of this application are described by using the accompanying drawings as an example. However, changes may also be made as required, and all the changes fall within the protection scope of this application. The accompanying drawings in embodiments of this application are only used to illustrate relative position relationships and do not represent an actual scale.

It should be noted that specific details are described in the following description to facilitate understanding of this application. However, this application can be implemented in numerous other manners different from those described herein, and persons skilled in the art can make similar inferences without departing from the connotation of this application. Therefore, this application is not limited to the specific implementations disclosed below.

An energy storage system may be a device that can store electric energy via a specific medium, and release, when necessary, the stored energy to generate electricity. The energy storage system may be used as a load balancing apparatus and a backup power supply; and used in an electronic device such as a server or a supercomputer, or used in an electric vehicle. Based on power consumption requirements of the energy storage system in different application scenarios, the energy storage system can be classified into a module-level energy storage system, a cabinet-level energy storage system, and a container-level energy storage system. The energy storage system may generally include a battery pack and a power converter. The battery pack is a main device that stores electric energy in the energy storage system. The power converter may be configured to perform power conversion on a current input to the battery pack or a current output from the battery pack, or may be configured to perform power conversion on a voltage input to the battery pack or a voltage output from the battery pack, so that power of the energy storage system matches power of an external power supply device or an electric device.

An energy storage system used in an electric vehicle is used as an example. To meet an energy requirement of the electric vehicle, a battery pack of the energy storage system is usually formed by connecting a plurality of battery modules in series, each battery module further includes a plurality of battery cells disposed in series, and each battery cell is formed by connecting a plurality of electrochemical cells in parallel. When the battery modules are connected, adjacent battery modules are generally connected by using a connection component such as a copper sheet or an aluminum sheet, and are tightened through a screw.

Generally, a connection impedance between battery cells and a connection impedance between battery modules are less than or equal to 0.1 m$\Omega$, and can be ignored. However, when the battery pack is in use, due to factors such as driving bump and salt spray corrosion of the electric vehicle, a reliability risk of a connection between battery cells or battery modules is increased. In particular, the connection component between the battery modules may be aged and decayed, or become abnormally loose at an end of system reliability. As a result, the impedance of the connection component increases abnormally, and an increased impedance causes the connection component to heat up abnormally when a current flows. When the current is high, a temperature of the connection component quickly rises to a high temperature. Under action of a continuous high temperature, a battery capacity may be abnormally attenuated, or even thermal runaway may occur, causing a fire. Alternatively, when the current is small, although there is no risk of thermal runaway, a continuous temperature imbalance of the battery pack accelerates battery aging, shortens a battery lifespan, and even causes other faults at the end of the battery lifespan, resulting in a safety accident.

Therefore, if an abnormal connection between the battery cells or the battery modules is detected in time, use safety of the battery can be effectively improved. A current solution is to detect a temperature at a pole of a battery cell or a battery module, to locate an abnormal connection at the pole. However, because a large quantity of thermocouples need to be disposed, costs of the battery pack are too high.

In view of this, embodiments of this application provide a battery pack. The battery pack can effectively determine an abnormal connection between battery cells or between battery modules without increasing hardware costs of a sampling detection circuit. This can improve safety of the battery pack. The following further describes this application in detail with reference to accompanying drawings and specific embodiments.

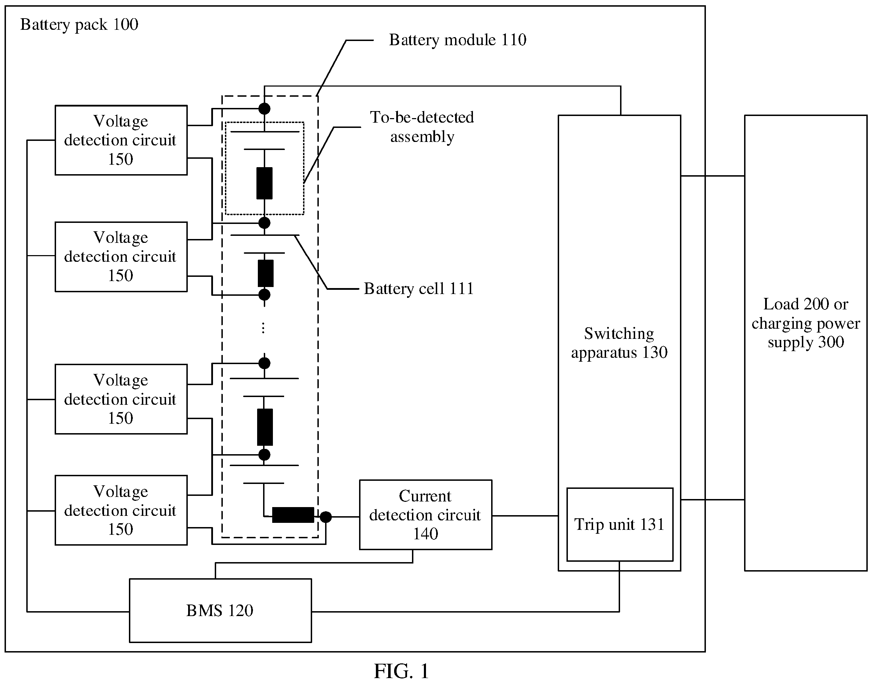

FIG. 1 is a schematic diagram of a structure of a battery pack 100 according to an embodiment of this application. The battery pack 100 may include one battery module 110, or may include two or more battery modules 110. First, a case in which there is one battery module 110 shown in FIG. 1 is used as an example for description. A positive connection terminal of the battery module 110 may be connected to a positive electrode of a load 200, and a negative connection terminal of the battery module 110 may be connected to a negative electrode of the load 200. In this case, the battery pack 100 may be configured to discharge to the load 200, and a loop formed by connecting the battery module 110 to the load 200 is a discharge loop. Alternatively, a positive connection terminal of the battery module 110 may be connected to a positive electrode of a charging power supply 300, and a negative connection terminal of the battery module 110 may be connected to a negative electrode of the charging power supply 300. In this case, the battery pack 100 may be charged by using the charging power supply 300, and a loop formed by connecting the battery module 110 to the charging power supply 300 is a charge loop.

To implement intelligent management and maintenance of the battery pack 100, and ensure safe running of the battery pack 100, the battery pack 100 may usually further include a battery management system (battery management system, BMS) 120. The BMS may monitor a status of the battery module 110 in real time, to cut off the charge/discharge loop in time when the battery module 110 is faulty. In an implementation, a switching apparatus 130 may be disposed in the charge/discharge loop of the battery pack 100, and a trip unit 131 may be disposed in the switching apparatus 130. When detecting that the battery module 110 is faulty, the BMS may control the trip unit 131 in the switching apparatus 130 to perform tripping processing, to disconnect the battery module 110 from the load 200 or the charging power supply 300, to achieve a purpose of cutting off the charge/discharge loop.

In this embodiment, the battery module 110 may further include a plurality of battery cells 111, and the plurality of battery cells 111 are connected in series. n (n is a positive integer and n≥2) battery cells 111 are used as an example. In this case, a positive electrode of a first battery cell 111 may be connected to a positive connection terminal of the battery module 110, and a negative electrode of an $n^{th}$ battery cell 111 may be connected to a negative connection terminal of the battery module 110.

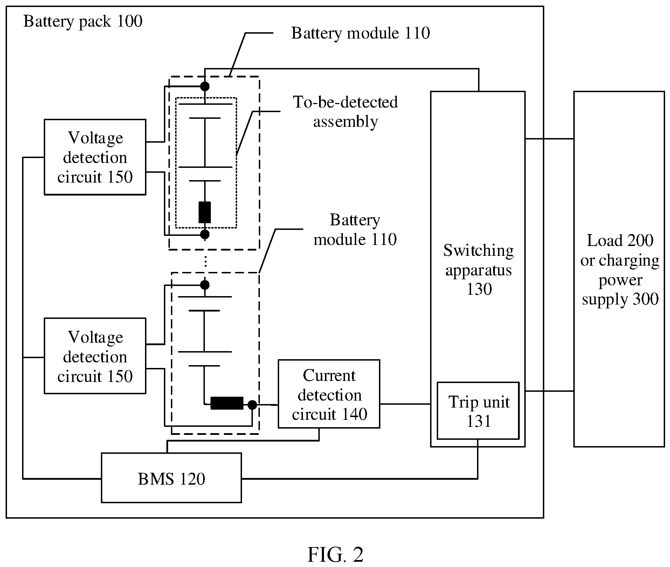

FIG. 2 is a schematic diagram of a structure of another battery pack 100 according to an embodiment of this application. In this embodiment, the battery pack 100 may include a plurality of battery modules 110, for example, m (m is a positive integer and m≥2). FIG. 2 shows an example of a case in which the battery pack 100 includes two battery modules 110. In a specific embodiment, the plurality of battery modules 110 are disposed in series, a positive connection terminal of a first battery module 110 may be connected to a positive electrode of a load 200, and a negative connection terminal of an $m^{th}$ battery module 110 may be connected to a negative electrode of the load 200, so as to form a discharge loop for discharging the load 200. Alternatively, a positive connection terminal of the first battery module 110 may be connected to a positive electrode of a charging power supply 300, and a negative connection terminal of the $m^{th}$ battery module 110 may be connected to a negative electrode of the charging power supply 300, so as to form a charge loop for charging each battery module 110.

In this embodiment, a structure of each battery module 110 may be set with reference to the embodiment shown in FIG. 1, that is, each battery module 110 may include a plurality of battery cells 111, and the plurality of battery cells 111 are connected in series. In addition, the battery pack 100 may also include a BMS and a switching apparatus 130, to implement intelligent management and maintenance of the battery pack 100. Details are not described herein again.

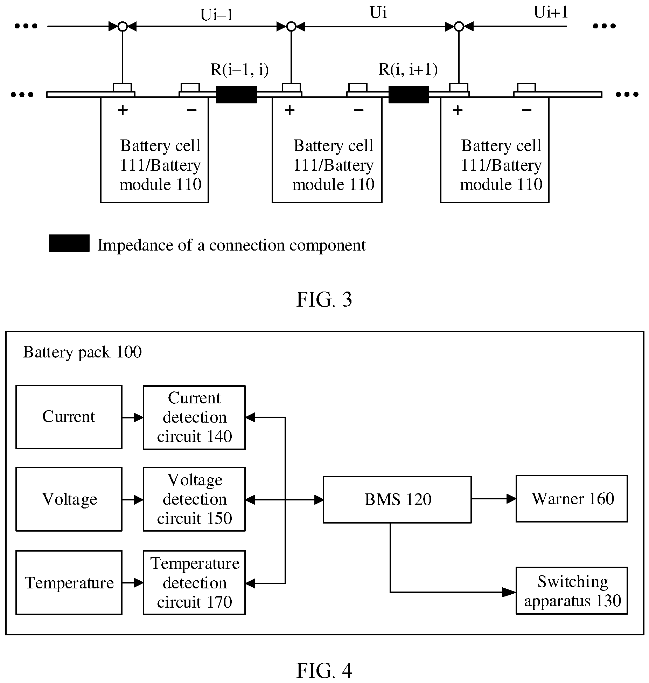

FIG. 3 is a schematic diagram of a partial structure of a battery pack 100 according to an embodiment of this application. When a plurality of battery modules 110 are connected in series, there is one connection component between any two adjacent battery modules 110. For example, for an $(i-1)^{th}$ (i is a positive integer and 2≤i≤m) battery module 110 and an $i^{th}$ battery module 110, the connection component between the two battery modules 110 is separately connected to a negative connection terminal of the $(i-1)^{th}$ battery module 110 and a positive connection terminal of the $i^{th}$ battery module 110, and the connection component may be considered as a connection component of the $i^{th}$ battery module 110, may also be considered as a connection component of the $(i+1)^{th}$ battery module 110. It may be understood that each battery module 110 has two connection components, and the two connection components are separately shared by the two battery modules 110 on the two sides.

Similarly, when a plurality of battery cells 111 are connected in series, there is one connection component between any two adjacent battery cells 111. For example, for an $(i-1)^{th}$ ($i$ is a positive integer and $2\leq i\leq n$) battery cell 111 and an $i^{th}$ battery cell 111, the connection component between the two battery cells 111 is separately connected to a negative electrode of the $(i-1)^{th}$ battery cell 111 and a positive electrode of the $i^{th}$ battery cell 111, and the connection component may be considered as a connection component of the $i^{th}$ battery cell 111, may also be considered as a connection component of the $(i+1)^{th}$ battery cell 111. Therefore, each battery cell 111 also has two connection components, and the two connection components are separately shared by the two battery cells 111 on the two sides.

As described above, when an abnormal connection occurs on the connection component of the battery module 110 or the connection component of the battery cell 111, an impedance of the connection component increases. Based on this, whether a connection fault occurs may be determined by obtaining the impedance of the connection component of the battery module 110 or the impedance the connection component of the battery cell 111. In this embodiment of this application, the battery module 110 or the battery cell 111 may be considered as a battery subpack, and the battery subpack and one connection component connected to an end of the battery subpack are used as a to-be-detected assembly, and the impedance value of each to-be-detected assembly is determined in a detection process. The following uses an example in which the battery subpack is a battery cell 111 to specifically describe a process of determining whether an abnormal connection occurs on the connection component of the battery subpack.

With reference to FIG. 1 and FIG. 3 again, in a specific embodiment, the battery pack 100 may further include a current detection circuit 140 and a voltage detection circuit 150. The current detection circuit 140 may be disposed in a charge/discharge loop of the battery pack 100, and is configured to detect a current of the charge/discharge loop. The voltage detection circuit 150 and the to-be-detected assembly are disposed in a one-to-one correspondence, and the voltage detection circuit 150 is configured to detect voltages at two ends of the to-be-detected assembly. In other words, an $i^{th}$ voltage detection circuit 150 may be configured to detect voltages at two ends of an $i^{th}$ to-be-detected assembly. In an implementation, the voltage detection circuit 150 may be disposed in parallel with the battery cell 111 and the connection component in the corresponding to-be-detected assembly. For example, two ends of a first voltage detection circuit 150 may be separately connected to a positive connection terminal of the battery module 110 and a negative electrode of a first battery cell 111, two ends of the $i^{th}$ voltage detection circuit 150 may be separately connected to a negative electrode of the $(i-1)^{th}$ battery cell 111 and a negative electrode of the $i^{th}$ battery cell 111, and two ends of the $n^{th}$ voltage detection circuit 150 may be separately connected to a negative electrode of an $(n-1)^{th}$ battery cell 111 and a negative connection terminal of the battery module 110. In other words, a voltage of the to-be-detected assembly detected by the voltage detection circuit 150 includes a voltage of the battery cell 111, a voltage shared by one connection component connected to an end of the battery cell 111. In this way, connection components at two ends of each battery cell 111 in the battery module 110 may be covered by a corresponding voltage detection circuit 150 for detection.

It is assumed that the current of the charge/discharge loop detected by the current detection circuit 140 is I, the voltage of the to-be-detected assembly detected by the $i^{th}$ voltage detection circuit 150 is Ui, a voltage of the $i^{th}$ battery cell 111 is OCVi, a resistance value of the $i^{th}$ battery cell 111 is Ri, and an impedance of a connection component between the $i^{th}$ battery cell 111 and the $(i-1)^{th}$ battery cell 111 is R(i-1, i), a voltage relationship may be represented as follows:

$$Ui = OCVi - I*(Ri + R(i-1, i))$$

It may be understood that the current I of the charge/discharge loop detected by the current detection circuit 140 is a negative value in a charging process, and is a positive value in a discharging process. When the battery pack 100 is in a normal working state, the impedance R(i-1, i) of the connection component connected to the battery cells 111 is almost zero. Therefore, a voltage shared by the connection component can be ignored, and a voltage detected by the voltage detection circuit 150 is close to a voltage OCVi of the battery cells 111. However, after a contact fault occurs on the connection component, the impedance of the connection component increases abnormally. As a result, a voltage value detected by the voltage detection circuit 150 is high in a charging process, and a voltage value detected by the voltage detection circuit 150 is low in a discharging process. Based on this principle, the impedance of each to-be-detected assembly may be calculated based on the detection value of the current detection circuit 140 and the detection value of the voltage detection circuit 150, to determine whether an abnormal connection occurs on the connection component in the to-be-detected assembly.

FIG. 4 is a schematic diagram of an architecture of a battery pack 100 according to an embodiment of this application. With reference to FIG. 3 and FIG. 4, in a specific embodiment, the BMS may be separately connected to the current detection circuit 140 and the voltage detection circuit 150, and may be configured to: separately obtain, based on a preset period, a current of a charge/discharge loop detected by the current detection circuit 140 and a voltage of a to-be-detected assembly detected by each voltage detection circuit 150, and separately generate a current sequence and a first voltage sequence for each to-be-detected assembly. The impedance of each to-be-detected assembly may be obtained through calculation based on the current sequence and the first voltage sequence. After the impedance of each to-be-detected assembly is determined, the impedance may be compared with a specified impedance threshold, and when the impedance of the to-be-detected assembly is greater than or equal to the impedance threshold, it is determined that an abnormal connection occurs on the connection component in the to-be-detected assembly.

For example, the BMS may continuously collect current values and voltage values at x (x is a positive integer and x≥1) moments. In this case, the current sequence includes currents of the charge/discharge loop at the x moments, and the current sequence may be represented as ($I_{t1}$, $I_{t2}$, ..., $I_{tk}$, $I_{tk}+1$, ..., and $I_{tx}$). Similarly, the first voltage sequence of each to-be-detected assembly also includes voltage values corresponding to the foregoing x moments. In this case, a first voltage sequence of an $i^{th}$ to-be-detected assembly may be represented as ($Ui_{t1}$, $Ui_{t2}$, ..., $Ui_{tk}$, $Ui_{tk+1}$, ..., and $Ui_{tx}$). The impedance $R_{celli}$ of the $i^{th}$ to-be-detected assembly may be obtained through calculation based on the first voltage sequence of the $i^{th}$ to-be-detected assembly and the current sequence. Specifically, the BMS may calculate, by using a linear regression method, the impedance of the to-be-detected assembly, but this is not limited.

After obtaining the impedance of the to-be-detected assembly, the BMS may be configured to: generate an impedance sequence ($R_{cell1}$, $R_{cell2}$, ..., $R_{celli}$, $R_{celli+1}$, ..., and $R_{celln}$) that includes the impedance of each to-be-detected assembly, determine a median or an average value of the impedance sequence, and further set the median or the average value of the impedance sequence as an impedance threshold. Certainly, in some other embodiments, the impedance threshold may also be a determined value pre-stored in the BMS. In this case, the impedance threshold may be set based on experience or experimental data, and details are not described herein again.

In some possible embodiments, before calculating the impedance of each to-be-detected assembly based on the current sequence and the first voltage sequence, the BMS may be configured to: determine whether the current sequence meets a preset condition, and perform, when the preset condition is met, the foregoing step of calculating the impedance. For example, the preset condition may be that a standard deviation $I_{std}$ of the current sequence is greater than or equal to a specified threshold $I_{std\ threshold}$. The standard deviation is a measure that indicates a dispersion degree of a group of data corresponding to an average value. For example, in this embodiment, a large standard deviation $I_{std}$ of the current sequence indicates a large difference between a majority of current values in the current sequence and an average value of the current sequence. On the contrary, a small standard deviation $I_{std}$ of the current sequence indicates that a majority of current values in the current sequence are close to an average value of the current sequence. In addition, the specified threshold $I_{std\ threshold}$

may be set based on experience or experimental data, and details are not described herein again.

In addition, before determining that the current sequence meets the preset condition, the BMS may be configured to: determine whether absolute values of differences between voltage values at one or more moments in the first voltage sequence and a voltage threshold are greater than or equal to a voltage difference threshold; and if yes, perform the step of determining whether the current sequence meets the preset condition.

Specifically, in a charging process, a current of a charge/discharge loop is a negative value. Therefore, if an abnormal connection occurs on the connection component in the to-be-detected assembly, a voltage value detected by the voltage detection circuit 150 is high. In this process, the BMS may be configured to determine whether voltage values at one or more moments in the first voltage sequence are higher than the voltage threshold by the voltage difference threshold. If yes, it indicates that the connection component has a risk of an abnormal connection, and determining of the current sequence may be performed for further confirmation in the next step. In a discharging process, a current of a charge/discharge loop is a positive value. Therefore, if an abnormal connection occurs on the connection component in the to-be-detected assembly, a voltage value detected by the voltage detection circuit 150 is low. In this process, the BMS may be configured to determine whether voltage values at one or more moments in the first voltage sequence are lower than the voltage threshold by the voltage difference threshold. If yes, it also indicates that the connection component has a risk of an abnormal connection. In this case, determining of the current sequence may be performed for further confirmation.

In a specific embodiment, after obtaining the voltages of the to-be-detected assemblies at a $k^{th}$ moment (k is a positive integer and 1≤k≤x), the BMS may be configured to: generate a temporary sequence ($U1_{tk}$, $U2_{tk}$, ..., $Ui_{tk}$, $Ui+1_{tk}$, ..., and $Un_{tk}$) that includes the voltages of the to-be-detected assemblies at the $k^{th}$ moment; and determine a median or an average value of the temporary sequence, and further set the median or the average value of the temporary sequence to the voltage threshold at the $k^{th}$ moment. That is, in this solution, voltage thresholds at different moments may be equal or may be unequal, and a voltage threshold at a moment is a median or an average number of voltage values at a moment in each first voltage sequence. Certainly, in some other embodiments, the voltage threshold may also be a determined value pre-stored in the BMS. In this case, the voltage threshold may be set based on experience or experimental data, and details are not described herein again. In addition, the voltage difference threshold may also be set based on experience or experimental data, and be pre-stored in the BMS. Details are not described herein again.

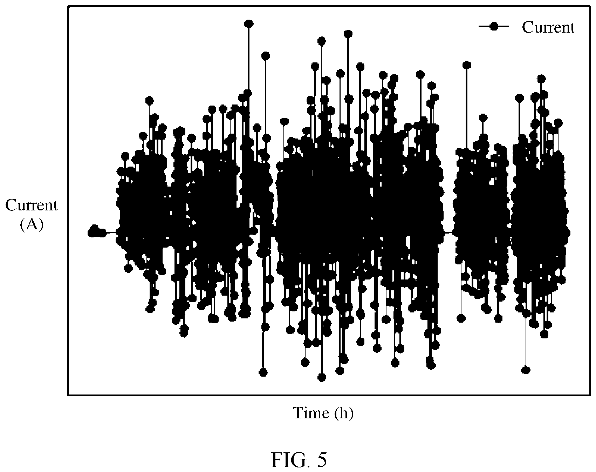

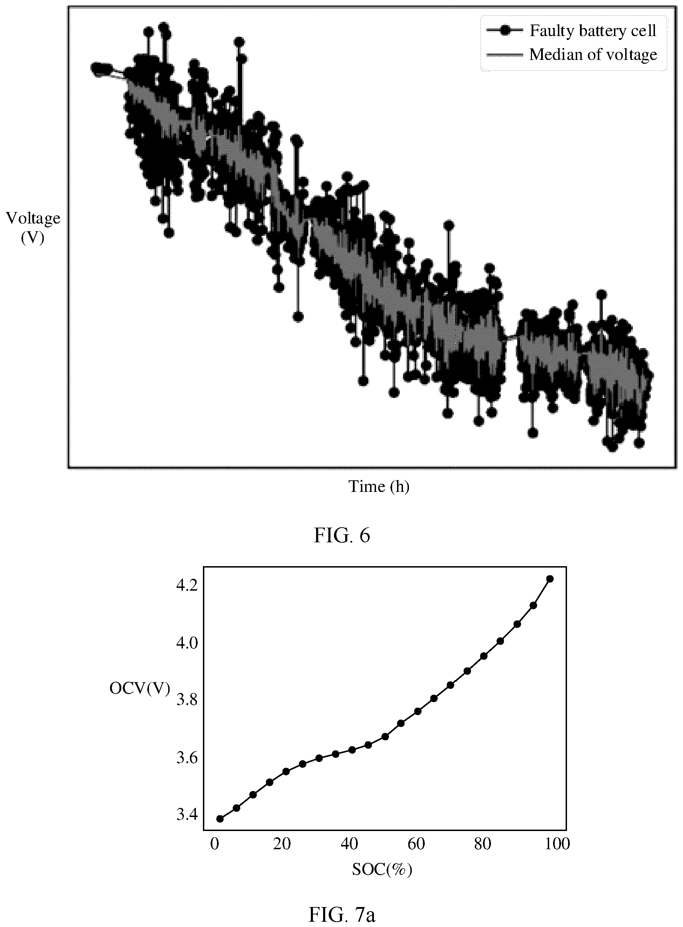

A battery module including 24 battery cells is used as an example. An actual running scenario of the battery module is simulated through an experiment. According to the manner provided in the foregoing embodiment, a current of a charge/discharge loop and a voltage of each to-be-detected assembly are separately collected based on a preset period, and a median of voltages of the 24 to-be-detected assemblies at each moment is obtained based on a first voltage sequence of each to-be-detected assembly. FIG. 5 shows collected current values of the charge/discharge loop. FIG. 6 is a diagram of comparison between voltages of a to-be-detected assembly with a connection fault and medians of voltages of 24 to-be-detected assemblies at different moments. The voltage of the to-be-detected assembly with the connection fault is shown by a straight line in FIG. 6, and the median of the voltages of the 24 to-be-detected assemblies at each moment is shown by a line with two points in FIG. 6.

With reference to FIG. 3 and FIG. 4 again, in some possible embodiments, if the collected current sequence does not meet the preset condition, for example, in some scenarios with an energy storage power plant, when the battery pack 100 is in a constant current charging or discharging state, the battery pack 100 may be controlled, based on a current charged or discharged state of the battery pack 100, to charge or discharge based on a preset current sequence, and then when the battery pack 100 is charged or discharged, a voltage of each to-be-detected assembly at a corresponding moment is obtained based on the preset current sequence, and a second voltage sequence of each to-be-detected assembly is generated. The impedance of each to-be-detected assembly is separately calculated based on the preset current sequence and the second voltage sequence, the impedance of each to-be-detected assembly is compared with the impedance threshold, and when the impedance of the to-be-detected assembly is greater than or equal to the impedance threshold, that an abnormal connection occurs on the connection component in the to-be-detected assembly is determined.

For example, the preset current sequence may also include current values at x moments. In this case, the preset current sequence may be represented as ($I'_{t1}$, $I'_{t2}$, ..., $I'_{tk}$, $I'_{tk+1}$, ..., and $I'_{tx}$). Based on the preset current sequence, the second voltage sequence of each to-be-detected assembly also includes voltage values corresponding to the foregoing m moments. In this case, the second voltage sequence of the $i^{th}$ to-be-detected assembly may be represented as ($U'i_{t1}$, $U'i_{t2}$, ..., $U'i_{tk}$, $U'i_{tk+1}$, ..., and $U'i_{tx}$). The impedance $R_{celli}$ of the $i^{th}$ to-be-detected assembly may be obtained through calculation based on the preset current sequence and the second voltage sequence of the $i^{th}$ to-be-detected assembly. Similarly, the BMS may calculate, by using a linear regression method, the impedance of the to-be-detected assembly, but this is not limited.

In some other possible embodiments, if the collected current sequence does not meet the preset condition, or the battery pack 100 does not meet a running scenario in which the battery pack 100 is excited based on the preset current sequence, the BMS may calculate the impedance of each to-be-detected assembly based on intrinsic information of the battery pack 100, and when the impedance of the to-be-detected assembly is greater than or equal to the impedance threshold, determine that an abnormal connection occurs on the connection component in the to-be-detected assembly.

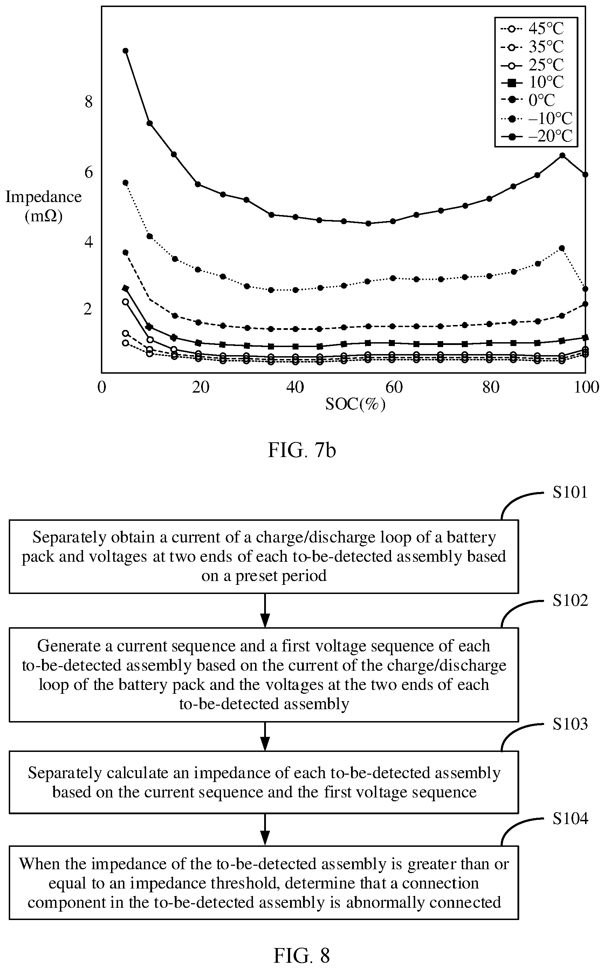

The intrinsic information of the battery pack may specifically include information such as an open-circuit voltage (open circuit voltage, OCV), a state of charge (state of charge, SOC), and an internal resistance. With reference to FIG. 7a and FIG. 7b, FIG. 7a is a curve diagram of a possible relationship between an open-circuit voltage and a state of charge of a battery pack; and FIG. 7b is a curve diagram of possible relationships between impedances of a to-be-detected assembly of the battery pack and states of charge at different temperatures. An impedance of the to-be-detected assembly may be obtained through calculation based on a relationship between related parameters of the battery pack disclosed in FIG. 7a and FIG. 7b. It should be noted that FIG. 7a and FIG. 7b each are only one curve diagram of intrinsic information of a possible battery pack as an example, and intrinsic information of different battery packs is also different. In actual application, corresponding calculation may be performed based on specific information of the battery pack, and details are not described herein again.

With reference to FIG. 4 again, in this embodiment of this application, the battery pack 100 may further include a warner 160. The BMS is connected to the warner 160, and may be configured to: when it is determined that an abnormal connection occurs on the connection component in the to-be-detected assembly, determine an abnormal risk level of the to-be-detected assembly based on the impedance of the to-be-detected assembly, and control, based on the abnormal risk level, the warner 160 to perform a corresponding warning. For example, in some implementations, the BMS may be configured to control, based on a warning sent by a warner, a trip unit in the switching apparatus 130 to perform trip processing, and cut off the charge/discharge loop of the battery pack 100, to facilitate offline maintenance. Alternatively, in some other implementations, a warning sent by the warner 160 may be controlled to notify a maintenance personnel to perform regular maintenance.

In addition, the battery pack 100 may further include a temperature detection circuit 170. The temperature detection circuit 170 may be configured to detect a temperature of the battery pack 100 in real time. The BMS may be connected to the temperature detection circuit 170, and may be configured to: when the temperature of the battery pack 100 exceeds a temperature threshold, control the warner 160 to send a warning, and cut off the charge/discharge loop of the battery pack 100 or notify the maintenance personnel to perform related maintenance.

With reference to FIG. 8, an embodiment of this application further provides a battery pack detection method. For a structure of the battery pack, refer to the descriptions in the foregoing embodiments. Details are not described herein again. The detection method may include the following steps.

Step S101: Separately obtain a current of a charge/discharge loop of a battery pack and voltages at two ends of each to-be-detected assembly based on a preset period.

Step S102: Generate a current sequence and a first voltage sequence of each to-be-detected assembly based on the current of the charge/discharge loop of the battery pack and the voltages at the two ends of each to-be-detected assembly.

Step S103: Separately calculate an impedance of each to-be-detected assembly based on the current sequence and the first voltage sequence.

Step S104: When the impedance of the to-be-detected assembly is greater than or equal to an impedance threshold, determine that a connection component in the to-be-detected assembly is abnormally connected.

In the foregoing method, the impedance of the to-be-detected assembly is calculated, and whether the connection component in the to-be-detected assembly is faulty can be effectively determined. This can improve use safety of the battery pack.

In the foregoing embodiment, the to-be-detected assembly includes one battery subpack and one connection component connected to an end of the battery subpack. The battery subpack may be a battery module, or may be a battery cell. This is not limited in this application. In other words, by using the foregoing detection method, only a topology structure of a sampling detection circuit is changed without increasing hardware costs of the sampling detection circuit, to be specific, a connection status between battery modules and a connection status between battery cells can be detected. Therefore, costs of the battery pack can be effectively reduced.

In some embodiments, before the separately calculating the impedance of each to-be-detected assembly based on the current sequence and the first voltage sequence, the detection method may further include:

determining whether the current sequence meets a preset condition, and if yes, performing step S103. For example, the preset condition may be that a standard deviation of the current sequence is greater than or equal to a specified threshold.

In some embodiments, before the determining that the current sequence meets the preset condition, the detection method may further include:

determining whether absolute values of differences between voltage values at one or more moments in the first voltage sequence and a voltage threshold are greater than or equal to a voltage difference threshold; and if yes, performing the step of determining whether the current sequence meets the preset condition; or if no, returning to step S101.

In the foregoing solution, when the absolute values of the differences between the voltage values at the one or more moments in the first voltage sequence and the voltage threshold are greater than or equal to the voltage difference threshold, it indicates that the connection component in the to-be-detected assembly has a risk of an abnormal connection. Therefore, determining of the current sequence may be performed for further confirmation.

In a possible embodiment, the voltage threshold may be a median or an average number of voltage values at one or more moments in each first voltage sequence. The median or the average number of the voltage values of each to-be-detected assembly at a same moment is used as a determining criterion. This can more accurately determine a detection voltage of the to-be-detected assembly.

In another possible embodiment, the voltage threshold may also be a pre-stored determined value. In this case, the voltage threshold may be set based on experience or experimental data. Details are not described herein again.

In some embodiments, if the collected current sequence does not meet the preset condition, for example, in some scenarios with an energy storage power plant, the battery pack is in a constant current charging or discharging state, and the detection method may further include:

controlling the battery pack to be charged or discharged based on a preset current sequence; obtaining the voltage of each to-be-detected assembly when the battery pack is charged based on the preset current sequence, and generating a second voltage sequence of each to-be-detected assembly; separately calculating the impedance of each to-be-detected assembly based on the preset current sequence and the second voltage sequence; and when the impedance of the to-be-detected assembly is greater than or equal to the impedance threshold, determining that the connection component in the to-be-detected assembly is abnormally connected.

In some other embodiments, if the collected current sequence does not meet the preset condition, and the battery pack does not meet a running scenario in which the battery pack is excited based on the preset current sequence, the detection method may further include:

calculating the impedance of each to-be-detected assembly based on intrinsic information of the battery pack; and

when the impedance of the to-be-detected assembly is greater than or equal to the impedance threshold, determining that the connection component in the to-be-detected assembly is abnormally connected.

In some embodiments, after the determining that the connection component in the to-be-detected assembly is abnormally connected, the detection method may further include:

determining an abnormal risk level based on the impedance of the to-be-detected assembly; and controlling, based on the abnormal risk level, a warner to perform a corresponding warning.

According to the foregoing solution, the battery pack can be maintained in time. This ensures safe running of the battery pack.

Based on a same technical concept, an embodiment of this application further provides a battery management system for controlling a battery pack. For a structure of the battery pack, refer to the descriptions in the foregoing embodiments. Details are not described herein again. The battery management system may include a communication unit and a processing unit.

The communication unit is configured to separately obtain a current of a charge/discharge loop of a battery pack and a voltage of each to-be-detected assembly based on a preset period.

The processing unit is configured to: generate a current sequence and a first voltage sequence of each to-be-detected assembly based on the current of the charge/discharge loop of the battery pack and the voltage of each to-be-detected assembly;

separately calculate an impedance of each to-be-detected assembly based on the current sequence and the first voltage sequence; and when the impedance of the to-be-detected assembly is greater than or equal to an impedance threshold, determine that a connection component in the to-be-detected assembly is abnormally connected.

In the foregoing solution, the impedance of the to-be-detected assembly is calculated, and whether the connection component in the to-be-detected assembly is faulty can be effectively determined. This can improve use safety of the battery pack.

In the foregoing embodiment, the to-be-detected assembly includes one battery subpack and one connection component connected to an end of the battery subpack. The battery subpack may be a battery module, or may be a battery cell. This is not limited in this application. In other words, by using the foregoing detection method, only a topology structure of a sampling detection circuit is changed without increasing hardware costs of the sampling detection circuit, to be specific, a connection status between battery modules and a connection status between battery cells can be detected. Therefore, costs of the battery pack can be effectively reduced.

In some embodiments, the processing unit is further configured to:
when it is determined that the current sequence meets a preset condition, separately calculate the impedance of each to-be-detected assembly based on the current sequence and the first voltage sequence. For example, the preset condition may be that a standard deviation of the current sequence is greater than or equal to a specified threshold.

In some embodiments, the processing unit is further configured to:
before determining that the current sequence meets the preset condition, determine that absolute values of differences between voltage values at one or more moments in the first voltage sequence and a voltage threshold are greater than or equal to a voltage difference threshold.

In a possible embodiment, the voltage threshold may be a median or an average number of voltages at the one or more moments in each first voltage sequence. The median or the average number of the voltage values of each to-be-detected assembly at a same moment is used as a determining criterion. This can more accurately determine a detection voltage of the to-be-detected assembly.

In another possible embodiment, the voltage threshold may also be a pre-stored determined value. In this case, the voltage threshold may be set based on experience or experimental data. Details are not described herein again.

In some embodiments, if the collected current sequence does not meet the preset condition, for example, in some scenarios with an energy storage power plant, the battery pack is in a constant current charging or discharging state, and the processing unit may be configured to:

control the battery pack to be charged or discharged based on a preset current sequence;
obtain the voltage of each to-be-detected assembly when the battery pack is charged based on the preset current sequence, and generate a second voltage sequence of each to-be-detected assembly; and
separately calculate the impedance of each to-be-detected assembly based on the preset current sequence and the second voltage sequence, and when the impedance of the to-be-detected assembly is greater than or equal to the impedance threshold, determine that the connection component in the to-be-detected assembly is abnormally connected.

In some embodiments, if the collected current sequence does not meet the preset condition, and the battery pack does not meet a running scenario in which the battery pack is excited based on the preset current sequence, the processing unit may be configured to:

calculate the impedance of each to-be-detected assembly based on intrinsic information of the battery pack; and
when the impedance of the to-be-detected assembly is greater than or equal to the impedance threshold, determine that the connection component in the to-be-detected assembly is abnormally connected.

In some embodiments, the processing unit is further configured to:

after determining that the connection component in the to-be-detected assembly is abnormally connected, determine an abnormal risk level based on the impedance of the to-be-detected assembly; and
control, based on the abnormal risk level, the warner to perform a corresponding warning.

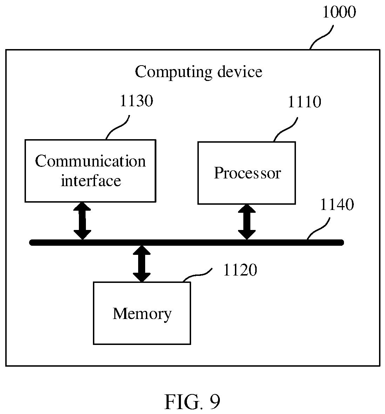

With reference to FIG. 9, an embodiment of this application further provides a computing device 1000. The computing device 1000 may be a chip or a chip system. Optionally, in this embodiment of this application, the chip system may include a chip, or may include a chip and another discrete device.

The computing device 1000 may include at least one processor 1110. The processor 1110 is coupled to a memory. Optionally, the memory may be located in the apparatus, the memory may be integrated with the processor, or the memory may be located outside the apparatus. For example, the computing device 1000 may further include at least one memory 1120. The memory 1120 stores a computer program, configuration information, a computer program, instructions, and/or data that are/is necessary for implementing any one of the foregoing embodiments. The processor 1110 may execute the computer program stored in the memory 1120, to complete the method in any one of the foregoing embodiments.

The computing device 1000 may further include a communication interface 1130, and the computing device 1000 may exchange information with another device by using the communication interface 1130. For example, the communication interface 1130 may be a transceiver, a circuit, a bus, a module, a pin, or another type of communication interface. When the computing device 1000 is a chip apparatus or a circuit, the communication interface 1130 in the apparatus may also be an input/output circuit, and may input information (or referred to as receiving information) and output information (or referred to as sending information). The processor is an integrated processor, a microprocessor, an integrated circuit, or a logic circuit. The processor may determine output information based on input information.

The coupling in this embodiment of this application may be an indirect coupling or a communication connection between apparatuses, units, or modules in an electrical form, a mechanical form, or another form, and is used for information exchange between the apparatuses, the units, or the modules. The processor 1110 may cooperate with the memory 1120 and the communication interface 1130. A specific connection medium between the processor 1110, the memory 1120, and the communication interface 1130 is not limited in this embodiment of this application.

Optionally, with reference to FIG. 9, the processor 1110, the memory 1120, and the communication interface 1130 are connected to each other by using a bus 1140. The bus 1140 may be a peripheral component interconnect (peripheral component interconnect, PCI) bus, an extended industry standard architecture (extended industry standard architecture, EISA) bus, and or the like. Buses may be classified into an address bus, a data bus, a control bus, and the like. For ease of representation, only one thick line is used to represent the bus in FIG. 9, but this does not mean that there is only one bus or only one type of bus.

In embodiments of this application, the processor may be a general-purpose processor, a digital signal processor, an application-specific integrated circuit, a field programmable gate array or another programmable logic device, a discrete gate or a transistor logic device, or a discrete hardware assembly, and may implement or perform the methods, steps, and logical block diagrams in embodiments of this application. The general-purpose processor may be a microprocessor, any conventional processor, or the like. The steps of the method in the embodiments applied with reference to embodiments of this application may be directly performed by a hardware processor, or may be performed by using a combination of hardware and software modules in the processor.

In embodiments of this application, the memory may be a nonvolatile memory, a hard disk drive (hard disk drive, HDD) or a solid-state drive (solid-state drive, SSD), or may be a volatile memory (volatile memory), for example, a random access memory (random access memory, RAM). The memory is any other medium that can carry or store expected program code in a form of instructions or a data structure and that can be accessed by a computer, but is not limited thereto. The memory in embodiments of this application may alternatively be a circuit or any other apparatus that can implement a storage function, and is configured to store the program instructions and/or the data.

In a possible implementation, the computing device 1000 may be used for a transmit end. Specifically, the computing device 1000 may be a transmit end, or may be an apparatus that can support the transmit end in implementing a function of the transmit end in any one of the foregoing embodiments. The memory 1120 stores a necessary computer program, a computer program, instructions and/or data for implementing the function of the transmit end in any one of the foregoing embodiments. The processor 1110 may execute the computer program stored in the memory 1120, to complete the method performed by the transmit end in any one of the foregoing embodiments. Used for the transmit end, a communication interface in the computing device 1000 may be configured to interact with a receive end, for example, send information to the receive end.

In another possible implementation, the computing device 1000 may be used for a receive end. Specifically, the computing device 1000 may be a receive end, or may be an apparatus that can support the receive end and implement a function of the receive end in any one of the foregoing embodiments. The memory 1120 stores a necessary computer program, a computer program, instructions and/or data for implementing the function of the receive end in any one of the foregoing embodiments. The processor 1110 may execute the computer program stored in the memory 1120, to complete the method performed by the receive end in any one of the foregoing embodiments. Used for the receive end, a communication interface in the computing device 1000 may be configured to interact with a transmit end, for example, receive information from the transmit end.

The computing device 1000 provided in this embodiment may be used for the transmit end, to complete the method performed by the transmit end, or may be used for the receive end, to complete the method performed by the receive end. Therefore, for technical effect that can be achieved by the computing device 1000, refer to the foregoing method embodiments. Details are not described herein again.

Based on the foregoing embodiments, an embodiment of this application further provides a computer program. When the computer program runs on a computer, the computer is enabled to implement the method provided in the embodiment shown in FIG. 8.

Based on the foregoing embodiments, an embodiment of this application further provides a computer-readable storage medium. The computer-readable storage medium stores a computer program. When the computer program is executed by a computer, the computer is enabled to the method provided in the embodiment shown in FIG. 8. The storage medium may be any available medium that can be accessed by the computer. The following is taken as an example but is not limited: The computer-readable medium may include a RAM, a read-only memory (read-only memory, ROM), an electrically erasable programmable read-only memory (electrically erasable programmable read-only memory, EEPROM1), a CD-ROM or other optical disk storage, a magnetic disk storage medium, or another magnetic storage device, a disk storage medium or other disk storage, or any other medium that can be used to carry or store expected program code in a form of instructions or a data structure and can be accessed by a computer.

All or a part of the technical solutions provided in embodiments of this application may be implemented by using software, hardware, firmware, or any combination thereof. When software is used to implement the embodiments, all or a part of the embodiments may be implemented in a form of a computer program product. The computer program product includes one or more computer instructions. When the computer program instructions are loaded and executed on a computer, all or a part of the procedures or functions according to embodiments of this application are generated. The computer may be a general-purpose computer, a dedicated computer, a computer network, an access network device, a terminal device, or another programmable apparatus. The computer instructions may be stored in a computer-readable storage medium, or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any available medium accessible by a computer, or a data storage device, such as a server or a data center, integrating one or more available media. The available medium may be a magnetic medium (for example, a floppy disk, a hard disk, or a magnetic tape), an optical medium (for example, a digital video disc (digital video disc, DVD)), a semiconductor medium, or the like.

The foregoing descriptions are only specific implementations of this application, but are not intended to limit the protection scope of this application. Any variation or replacement readily figured out by persons skilled in the art within the technical scope disclosed in this application shall fall within the protection scope of this application. Therefore, the protection scope of this application shall be subject to the protection scope of the claims.

## Claims

1. A battery pack, comprising a plurality of battery subpacks and voltage detection circuits, a current detection circuit, and a battery management system BMS, wherein the plurality of battery subpacks are connected in series to a charge/discharge loop of the battery pack, every two adjacent battery subpacks are connected by using a connection component, and each battery subpack and one connection component connected to an end of the battery subpack form one to-be-detected assembly, wherein

   the current detection circuit is configured to detect a current of the charge/discharge loop; the voltage detection circuit and the to-be-detected assembly are disposed in a one-to-one correspondence, and the voltage detection circuit is configured to detect voltages at two ends of the to-be-detected assembly; and

the BMS is configured to: separately obtain the current of the charge/discharge loop and voltages at two ends of each to-be-detected assembly based on a preset period, generate a current sequence and a first voltage sequence of each to-be-detected assembly, separately calculate an impedance of each to-be-detected assembly based on the current sequence and the first voltage sequence, and when the impedance is greater than or equal to an impedance threshold, determine that the connection component in the to-be-detected assembly is abnormally connected.

2. The battery pack according to claim 1, wherein the BMS is specifically configured to:
when the current sequence meets a preset condition, separately calculate the impedance of each to-be-detected assembly based on the current sequence and the first voltage sequence.

3. The battery pack according to claim 2, wherein the BMS is configured to: when the current sequence does not meet the preset condition, control the battery pack to be charged or discharged based on a preset current sequence; obtain voltages at the two ends of each to-be-detected assembly when the battery pack is charged or discharged based on the preset current sequence, and generate a second voltage sequence of each to-be-detected assembly; and separately calculate the impedance of each to-be-detected assembly based on the preset current sequence and the second voltage sequence, and when the impedance is greater than or equal to the impedance threshold, determine that the connection component in the to-be-detected assembly is abnormally connected.

4. The battery pack according to claim 2, wherein the BMS is configured to: when the current sequence does not meet the preset condition, calculate the impedance of each to-be-detected assembly based on intrinsic information of the battery pack, and when the impedance is greater than or equal to the impedance threshold, determine that the connection component in the to-be-detected assembly is abnormally connected.

5. The battery pack according to any one of claims 2 to 4, wherein the preset condition is that a standard deviation of the current sequence is greater than or equal to a specified threshold.

6. The battery pack according to any one of claims 2 to 5, wherein the BMS is further configured to:
before determining whether the current sequence meets the preset condition, determine that absolute values of differences between voltage values at one or more moments in the first voltage sequence and a voltage threshold are greater than or equal to a voltage difference threshold.

7. The battery pack according to claim 6, wherein the voltage threshold is a median or an average number of voltage values at one or more moments in each first voltage sequence.

8. The battery pack according to any one of claims 1 to 7, further comprising a warner, wherein the BMS is further configured to:

after it is determined that the connection component is abnormally connected, determine an abnormal risk level based on the impedance; and

control, based on the abnormal risk level, the warner to perform a corresponding warning.

9. The battery pack according to any one of claims 1 to 8, wherein

when the battery subpack is a battery module, the battery pack comprises a plurality of battery modules connected in series, and each battery module comprises a plurality of battery cells connected in series; or

when the battery subpack is a battery cell, the battery pack comprises a plurality of battery cells connected in series.

10. A battery pack, comprising a plurality of battery subpacks and voltage detection circuits, a current detection circuit, and a battery management system BMS, wherein the plurality of battery subpacks are connected in series to a charge/discharge loop of the battery pack, every two adjacent battery subpacks are connected by using a connection component, and each battery subpack and one connection component connected to an end of the battery subpack form one to-be-detected assembly, wherein

the current detection circuit is configured to detect a current of the charge/discharge loop;

the voltage detection circuit and the to-be-detected assembly are disposed in a one-to-one correspondence, and the voltage detection circuit is configured to detect voltages at two ends of the to-be-detected assembly; and

the BMS is configured to: obtain the current of the charge/discharge loop based on a preset period and generate a current sequence; when the current sequence does not meet a preset condition, control the battery pack to be charged or discharged based on a preset current sequence; obtain voltages at two ends of each to-be-detected assembly when the battery pack is charged or discharged based on the preset current sequence, and generate a second voltage sequence of each to-be-detected assembly; and separately calculate an impedance of each to-be-detected assembly based on the preset current sequence and the second voltage sequence, and when the impedance is greater than or equal to an impedance threshold, determine that the connection component in the to-be-detected assembly is abnormally connected.

11. A battery pack, comprising a plurality of battery subpacks, a current detection circuit, and a battery management system BMS, wherein the plurality of battery subpacks are connected in series to a charge/discharge loop of the battery pack, every two adjacent battery subpacks are connected by using a connection component, and each battery subpack and one connection component connected to an end of the battery subpack form one to-be-detected assembly, wherein

the current detection circuit is configured to detect a current of the charge/discharge loop; and the BMS is configured to: obtain the current of the charge/discharge loop based on a preset period and generate a current sequence; when the current sequence does not meet a preset condition, calculate an impedance of each to-be-detected assembly based on intrinsic information of the battery pack; and when the impedance is greater than or equal to an impedance threshold, determine that the connection component in the to-be-detected assembly is abnormally connected.

12. The battery pack according to claim 10 or 11, wherein the preset condition is that a standard deviation of the current sequence is greater than or equal to a specified threshold.

13. An energy storage system, comprising a power converter and the battery pack according to any one of claims 1 to 12, wherein the power converter is configured to perform power conversion on a current and/or a voltage input to the battery pack, or a current and/or a voltage output from the battery pack.

14. A battery pack detection method, wherein the detection method comprises:

separately obtaining a current of a charge/discharge loop of a battery pack and voltages at two ends of each to-be-detected assembly based on a preset period, wherein the battery pack comprises a plurality of battery subpacks, and each to-be-detected assembly comprises one battery subpack and one connection component connected to an end of the battery subpack;
generating a current sequence and a first voltage sequence of each to-be-detected assembly based on the current of the charge/discharge loop and the voltages at the two ends of each to-be-detected assembly;
separately calculating an impedance of each to-be-detected assembly based on the current sequence and the first voltage sequence; and
when the impedance is greater than or equal to an impedance threshold, determining that the connection component in the to-be-detected assembly is abnormally connected.

15. The detection method according to claim 14, further comprising:
when it is determined that the current sequence meets a preset condition, separately calculating the impedance of each to-be-detected assembly based on the current sequence and the first voltage sequence.

16. The detection method according to claim 15, further comprising:

when it is determined that the current sequence does not meet the preset condition, controlling the battery pack to be charged or discharged based on a preset current sequence;
obtaining voltages at the two ends of each to-be-detected assembly when the battery pack is charged based on the preset current sequence, and generating a second voltage sequence of each to-be-detected assembly;
separately calculating the impedance of each to-be-detected assembly based on the preset current sequence and the second voltage sequence; and
when the impedance is greater than or equal to the impedance threshold, determining that the connection component in the to-be-detected assembly is abnormally connected.

17. The detection method according to claim 15, further comprising:

when it is determined that the current sequence does not meet the preset condition, calculating the impedance of each to-be-detected assembly based on intrinsic information of the battery pack; and
when the impedance is greater than or equal to the impedance threshold, determining that the connection component is abnormally connected.

18. The detection method according to any one of claims 15 to 17, wherein the preset condition is that a standard deviation of the current sequence is greater than or equal to a specified threshold.

19. The detection method according to any one of claims 15 to 18, wherein before the determining whether the current sequence meets the preset condition, the detection method further comprises:
    determining that absolute values of differences between voltage values at one or more moments in the first voltage sequence and a voltage threshold are greater than or equal to a voltage difference threshold.

20. The detection method according to claim 19, wherein the voltage threshold is a median or an average number of voltage values at one or more moments in each first voltage sequence.

21. The detection method according to any one of claims 14 to 20, wherein after the determining that the connection component is abnormally connected, the detection method further comprises:

    determining an abnormal risk level based on the impedance; and
    controlling, based on the abnormal risk level, a warner to perform a corresponding warning.

22. A battery management system, comprising:

    a communication unit, configured to separately obtain a current of a charge/discharge loop of a battery pack and voltages at two ends of each to-be-detected assembly based on a preset period, wherein the battery pack comprises a plurality of battery subpacks, and each to-be-detected assembly comprises one battery subpack and one connection component connected to an end of the battery subpack; and
    a processing unit, configured to: generate a current sequence and a first voltage sequence of each to-be-detected assembly based on the current of the charge/discharge loop and the voltages at the two ends of each to-be-detected assembly;
    separately calculate an impedance of each to-be-detected assembly based on the current sequence and the first voltage sequence; and
    when the impedance is greater than or equal to an impedance threshold, determine that the connection component in the to-be-detected assembly is abnormally connected.

23. The battery management system according to claim 22, wherein the processing unit is further configured to:

when it is determined that the current sequence meets a preset condition, separately calculate the impedance of each to-be-detected assembly based on the current sequence and the first voltage sequence.

24. The battery management system according to claim 23, wherein the processing unit is further configured to:

    when it is determined that the current sequence does not meet the preset condition, control the battery pack to be charged or discharged based on a preset current sequence;
    obtain voltages at the two ends of each to-be-detected assembly when the battery pack is charged based on the preset current sequence, and generate a second voltage sequence of each to-be-detected assembly; and
    separately calculate the impedance of each to-be-detected assembly based on the preset current sequence and the second voltage sequence, and when the impedance is greater than or equal to the impedance threshold, determine that the connection component in the to-be-detected assembly is abnormally connected.

25. The battery management system according to claim 23, wherein the processing unit is further configured to:

    when it is determined that the current sequence does not meet the preset condition, calculate the impedance of each to-be-detected assembly based on intrinsic information of the battery pack; and
    when the impedance is greater than or equal to the impedance threshold, determine that the connection component in the to-be-detected assembly is abnormally connected.

26. The battery management system according to any one of claims 23 to 25, wherein the preset condition is that a standard deviation of the current sequence is greater than or equal to a specified threshold.

27. The battery management system according to any one of claims 23 to 26, wherein the processing unit is further configured to:
    before determining whether the current sequence meets the preset condition, determine that absolute values of differences between voltage values at one or more moments in the first voltage sequence and a voltage threshold are greater than or equal to a voltage difference threshold.

28. The battery management system according to claim 27, wherein the voltage threshold is a median or an average number of voltage values at one or more moments in each first voltage sequence.

29. The battery management system according to any one of claims 22 to 28, wherein the processing unit is further configured to:

after it is determined that the connection component is abnormally connected, determine an abnormal risk level based on the impedance; and
control, based on the abnormal risk level, a warner to perform a corresponding warning.

FIG. 1

EP 4 545 994 A1

FIG. 2

Impedance of a connection component

FIG. 3

FIG. 4

Time (h)

FIG. 5

Voltage
(V)

Time (h)

FIG. 6

FIG. 7a

FIG. 7b

FIG. 8

1000

Computing device

1130                                          1110

Communication
interface                                Processor

1140

Memory

1120

FIG. 9

## INTERNATIONAL SEARCH REPORT

| International application No. |
| --- |
| **PCT/CN2022/115790** |

| A. | CLASSIFICATION OF SUBJECT MATTER |
| --- | --- |

G01R 31/396(2019.01)i;  G01R 31/392(2019.01)i;  G01R 31/389(2019.01)i;  G01R 31/3842(2019.01)i;  H01M 10/48(2006.01)n

According to International Patent Classification (IPC) or to both national classification and IPC

| B. | FIELDS SEARCHED |
| --- | --- |

Minimum documentation searched (classification system followed by classification symbols)

G01R31/-;H01M10/48

Documentation searched other than minimum documentation to the extent that such documents are included in the fields searched

Electronic data base consulted during the international search (name of data base and, where practicable, search terms used)

CNTXT; ENTXTC; ENTXT, VEN, CNKI, ISI: 华为, 发明人, 电池, 内阻, 电阻, 阻抗, 连接, 接触, 异常, 故障, 序列, 数组, 线性回归, 最小二乘法, resistance, impedance, connect+, contact , joint, fault, array, serial, lease square, linear,

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | 徐佳宁 (XU, Jianing). "串联电池组接触电阻故障诊断分析 (Series Battery Pack's Contact Resistance Fault Diagnosis Analysis)" 电工技术学报 (Transactions of China Electrotechnical Society), Vol. 32, No. 18, 23 June 2017 (2017-06-23), entire document | 1-5, 8-18, 21-26, 29 |
| Y | 徐佳宁 (XU, Jianing). "串联电池组接触电阻故障诊断分析 (Series Battery Pack's Contact Resistance Fault Diagnosis Analysis)" 电工技术学报 (Transactions of China Electrotechnical Society), Vol. 32, No. 18, 23 June 2017 (2017-06-23), entire document | 6, 7, 19, 20, 27, 28 |
| X | CN 103399282 A (TSINGHUA UNIVERSITY) 20 November 2013 (2013-11-20) description, paragraphs 5-58, and figures 1-5 | 1, 8, 9, 13, 14, 21, 22, 29 |
| Y | CN 103399282 A (TSINGHUA UNIVERSITY) 20 November 2013 (2013-11-20) description, paragraphs 5-58, and figures 1-5 | 6, 7, 19, 20, 27, 28 |
| A | US 2014227571 A1 (PAGANELLI, G. et al.) 14 August 2014 (2014-08-14) entire document | 1-29 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **28 October 2022** | **20 January 2023** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2022/115790** |

### C. DOCUMENTS CONSIDERED TO BE RELEVANT

| Category* | Citation of document, with indication, where appropriate, of the relevant passages | Relevant to claim No. |
| --- | --- | --- |
| A | CN 103983888 A (SHANGYU ANKA TRAILER PART CO., LTD. et al.) 13 August 2014 (2014-08-13)<br>  entire document | 1-29 |
| A | US 2007052424 A1 (FUJITSU LTD.) 08 March 2007 (2007-03-08)<br>  entire document | 1-29 |
| A | US 2016069965 A1 (GM GLOBAL TECHNOLOGY OPERATIONS LLC) 10 March 2016 (2016-03-10)<br>  entire document | 1-29 |
| A | CN 107942254 A (DONGHUA UNIVERSITY) 20 April 2018 (2018-04-20)<br>  entire document | 1-29 |

Form PCT/ISA/210 (second sheet) (January 2015)

**INTERNATIONAL SEARCH REPORT**
Information on patent family members

International application No.

**PCT/CN2022/115790**

| Patent document cited in search report | | | Publication date (day/month/year) | Patent family member(s) | | | Publication date (day/month/year) |
|---|---|---|---|---|---|---|---|
| CN | 103399282 | A | 20 November 2013 | CN | 103399282 | B | 29 July 2015 |
| US | 2014227571 | A1 | 14 August 2014 | CN | 103718054 | A | 09 April 2014 |
| | | | | EP | 2721428 | A1 | 23 April 2014 |
| | | | | WO | 2012172030 | A1 | 20 December 2012 |
| | | | | FR | 2976676 | A1 | 21 December 2012 |
| | | | | CN | 103718054 | B | 26 April 2017 |
| | | | | FR | 2976676 | B1 | 12 December 2014 |
| | | | | EP | 2721428 | B1 | 18 March 2015 |
| | | | | US | 9865902 | B2 | 09 January 2018 |
| CN | 103983888 | A | 13 August 2014 | CN | 103983888 | B | 15 February 2017 |
| US | 2007052424 | A1 | 08 March 2007 | CN | 1929188 | A | 14 March 2007 |
| | | | | KR | 20070027424 | A | 09 March 2007 |
| | | | | EP | 1760477 | A2 | 07 March 2007 |
| | | | | JP | 2007071632 | A | 22 March 2007 |
| | | | | EP | 1760477 | A3 | 10 August 2011 |
| | | | | KR | 770727 | B1 | 22 October 2007 |
| | | | | JP | 5092218 | B2 | 05 December 2012 |
| US | 2016069965 | A1 | 10 March 2016 | CN | 105403803 | A | 16 March 2016 |
| | | | | DE | 102015114455 | A1 | 10 March 2016 |
| CN | 107942254 | A | 20 April 2018 | None | | | |

Form PCT/ISA/210 (patent family annex) (January 2015)